# EUROPEAN PATENT SPECIFICATION

(11) **EP 3 290 474 B1**
(45) Date of publication and mention of the grant of the patent: **09.09.2020**
(21) Application number: 15890740.2
(22) Date of filing: 30.04.2015
(51) Int. Cl.: C08L 63/00, H01L 23/29, H01L 23/31, C08G 59/68

(54) **ENCAPSULATING RESIN COMPOSITION AND ELECTRONIC COMPONENT DEVICE**
VERKAPSELUNGHARZZUSAMMENSETZUNG UND VORRICHTUNG MIT ELEKTRONISCHEN KOMPONENTEN
COMPOSITION DE RÉSINE D'ENCAPSULATION ET DISPOSITIF À COMPOSANTS ÉLECTRONIQUES

(43) Date of publication of application: 07.03.2018
(73) Proprietor: Sumitomo Bakelite Co.,Ltd., Tokyo 140-0002 (JP)
(72) Inventor: NAKAO Masaru, Tokyo 140-0002 (JP); KURODA Hirofumi, Tokyo 140-0002 (JP)
(74) Representative: Müller-Boré & Partner Patentanwälte PartG mbB
(86) International application number: PCT/JP2015/062937
(87) International publication number: WO 2016/174757

(56) References cited:
- JP-A- 2005 075 915
- JP-A- 2006 265 415
- JP-A- 2011 046 866
- JP-A- 2012 233 078
- JP-A- 2013 159 746
- JP-A- 2013 249 458
- JP-A- 2014 009 232
- JP-A- 2015 067 618

## Description

### TECHNICAL FIELD

The present invention relates to a resin composition for sealing and an electronic component device using the resin composition.

### BACKGROUND ART

Electronic components such as a diode, a transistor, and an integrated circuit are distributed to the market or incorporated into electronic instruments, as electronic component devices sealed with a cured substance of an epoxy resin composition or the like. Generally, the epoxy resin composition used in the sealing material is composed of an epoxy resin, a phenolic resin-based curing agent, an inorganic filler, a coupling agent, and the like. In recent years, as electronic instruments have become increasingly compactified, lightened, and improved in terms of performance, electronic components have been integrated on a large scale, and accordingly, the performance required for the sealing material (resin composition for sealing) has also improved. Specific examples of the performance required for the sealing material include adhesion, solder resistance, fluidity, heat resistance, high-temperature storage characteristics, and the like.

Under these circumstances, a resin composition for sealing a semiconductor that contains a mercapto group-containing compound such as mercapto group-containing alkoxysilane is developed (see Patent Document 1). The addition of a mercapto group-containing compound brings about an effect of improving the adhesion with respect to electronic components and the like.

Meanwhile, in recent years, as a material such as a bonding wire used for connecting an electronic component to a lead frame, instead of gold, inexpensive copper has been used. However, electronic component devices including a copper wire do not have sufficient high-temperature storage characteristics in some cases. For the electronic component devices in which a copper member such as a copper wire is used, much better high-temperature storage characteristics are required, and hence there is a demand for the development of a resin composition for sealing that is suitable for sealing such electronic components.

### RELATED DOCUMENT

### PATENT DOCUMENT

[Patent Document 1] Japanese Laid-open Patent Publication No. 2008-201873. Curable epoxy resin compositions for sealing semiconductor devices comprising an aromatic amide compound containing a hydroxyl group on the aromatic ring are disclosed in JP-A-2015067618.

### SUMMARY OF THE INVENTION

### TECHNICAL PROBLEM

The present invention has been made in consideration of the circumstances described above, and an object thereof is to provide a resin composition for sealing which has sufficient adhesion and enables an electronic component device obtained using the resin composition to exhibit excellent high-temperature storage characteristics, and to provide an electronic component device obtained using the resin composition for sealing as a sealing material.

### SOLUTION TO PROBLEM

A resin composition for sealing according to the present invention for achieving the aforementioned object contains an epoxy resin (A), a curing agent (B), an inorganic filler (C), and a compound (D) represented by Formula (1).

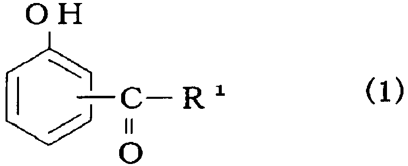

R¹ is represented by Formula (2) 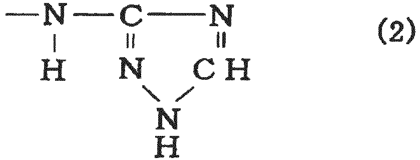 and a curing accelerator F) which is an adduct of a phosphine compound and a quinone compound. In the resin composition for sealing a content of the compound (D) is preferably equal to or greater than 0.01% by mass and equal to or less than 1% by mass. The content of each component is a ratio with respect to the total amount of the resin composition for sealing (hereinafter, the same shall be applied).

The resin composition for sealing preferably further contains a coupling agent (E), and the coupling agent (E) preferably includes a silane coupling agent (E1) having a mercapto group.

In the resin composition for sealing a content of the silane coupling agent (E1) having a mercapto group is preferably equal to or greater than 0.01% by mass and equal to or less than 0.1% by mass.

The resin composition for sealing contains a curing accelerator (F), which is an adduct of a phosphine compound and a quinone compound.

The resin composition for sealing is preferably used for sealing an electronic component to which a copper wire is connected.

An electronic component device for achieving the aforementioned object includes an electronic component and a sealing material sealing the electronic component, in which the sealing material is a cured substance of the resin composition for sealing discussed above.

The electronic component device preferably has a copper wire connected to the electronic component.

### ADVANTAGEOUS EFFECTS OF INVENTION

The resin composition for sealing contains the specific compound (D) having a hydroxybenzoyl group. Therefore, the resin composition can achieve both the sufficient adhesion and the excellent high-temperature storage characteristics of the obtained electronic component device.

In the electronic component device the resin composition for sealing is used as a sealing material. Therefore, the adhesion between the sealing material and the electronic component or the like is sufficient, and the high-temperature storage characteristics are also excellent.

### BRIEF DESCRIPTION OF THE DRAWINGS

The aforementioned object and other objects, characteristics, and advantages will be further clarified by suitable embodiments described below and the following drawings attached thereto.

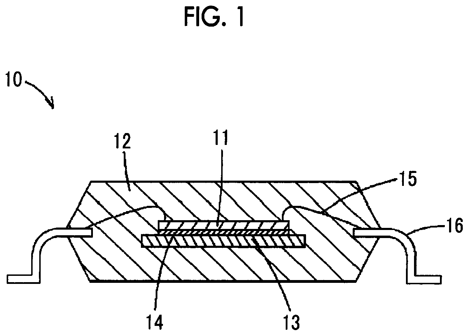

FIG. 1 is a cross-sectional view showing an electronic component device according to a second embodiment of the present invention.

### DESCRIPTION OF EMBODIMENTS

Hereinafter, the embodiments specifically showing the present invention will be described with reference to the attached drawings as appropriate.

### [Resin composition for sealing]

The resin composition for sealing according to a first embodiment of the present invention contains an epoxy resin (A), a curing agent (B), an inorganic filler (C), and a compound (D).

### [Epoxy resin (A)]

The epoxy resin (A) refers to a compound (a monomer, an oligomer, and a polymer) having two or more epoxy groups in one molecule, and the molecular weight as well as the molecular structure thereof are not particularly limited. Examples of the epoxy resin (A) include a crystalline epoxy resin such as a biphenyl-type epoxy resin, a bisphenol-type epoxy resin, or a stilbene-type epoxy resin; a novolac-type epoxy resin such as a phenol novolac-type epoxy resin or a cresol novolac-type epoxy resin; a polyfunctional epoxy resin such as a triphenol methane-type epoxy resin or an alkyl-modified triphenol methane-type epoxy resin; a phenol aralkyl-type epoxy resin such as a phenol aralkyl-type epoxy resin having a phenylene skeleton or a phenol aralkyl-type epoxy resin having a biphenylene skeleton; a naphthol-type epoxy resin such as dihydroxynaphthalene-type epoxy resin or an epoxy resin obtained by the glycidyl etherification of a dimer of dihydroxynaphthalene; a triazine nucleus-containing epoxy resin such as triglycidyl isocyanurate or monoallyl diglycidyl isocyanurate; a bridged cyclic hydrocarbon compound-modified phenol-type epoxy resin such as dicyclopentadiene-modified phenol-type epoxy resin; and the like. One kind of these may be used singly, or two or more kinds thereof may be used in combination.

As the epoxy resin (A), a phenol aralkyl-type epoxy resin represented by Formula (3) and a biphenyl-type epoxy resin represented by Formula (4) are preferable.

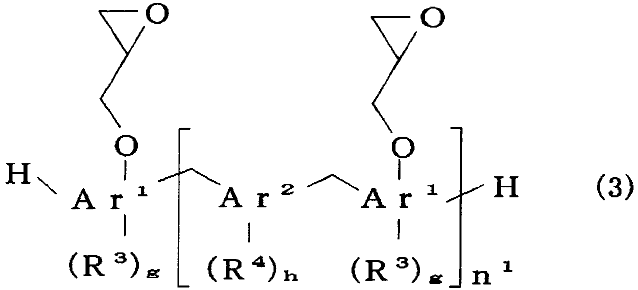

In Formula (3), Ar¹ represents a phenylene group (a group including a phenol structure obtained by removing hydrogen atoms from phenol by the number of bonds) or a naphthylene group (a group including a naphthalene structure obtained by removing hydrogen atoms from naphthalene by the number of bonds). In a case where Ar¹ represents a naphthylene group, a glycidyl ether group may be bonded to any of the α-position and the β-position. Ar² represents any one of a phenylene group, a biphenylene group (a group including a biphenylene structure obtained by removing hydrogen atoms from biphenyl by the number of bonds), and a naphthylene group. R³ and R⁴ each independently represent a hydrocarbon group having 1 to 10 carbon atoms. g represents an integer of 0 to 5 (here, in a case where Ar¹ represents a phenylene group, g represents an integer of 0 to 3). h represents an integer of 0 to 8 (here, in a case where Ar² represents a phenylene group, h represents an integer of 0 to 4, and in a case where Ar² represents a biphenylene group, h represents an integer of 0 to 6). n¹ represents a degree of polymerization, and the average thereof is 1 to 3.

As Ar¹, a phenylene group is preferable. As Ar², a phenylene group or a biphenylene group is preferable. In a case where Ar² represents a phenylene group or a biphenylene group (in a case where a phenylene skeleton or a biphenylene skeleton is introduced into the resin), flame retardancy can also be improved. In a case where g and h in R³ and R⁴ are not zero, examples of the hydrocarbon group having 1 to 10 carbon atoms include an alkyl group such as a methyl group or an ethyl group, an alkenyl group such as a vinyl group, an aryl group such as a phenyl group, and the like. g and h are preferably zero.

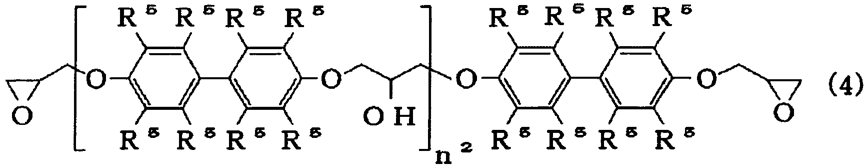

In Formula (4), a plurality of R^{5'} s each independently represent a hydrogen atom or a hydrocarbon group having 1 to 4 carbon atoms. n² represents a degree of polymerization, and the average thereof is 0 to 4. Examples of the hydrocarbon group having 1 to 4 carbon atoms include an alkyl group such as a methyl group or an ethyl group, an alkenyl group such as a vinyl group, and the like.

Although the content of the epoxy resin (A) is not particularly limited, the lower limit thereof is preferably 2% by mass and more preferably 4% by mass. In a case where the content of the epoxy resin (A) is equal to or greater than the aforementioned lower limit, sufficient adhesion and the like can be exhibited. The upper limit of the content of the epoxy resin (A) is preferably 20% by mass, and more preferably 10% by mass. In a case where the content of the epoxy resin (A) is equal to or less than the aforementioned upper limit, sufficient low water absorption properties, low thermal expansion properties, or the like are exhibited.

### [Curing agent (B)]

The curing agent (B) is not particularly limited as long as it is a component that can cure the epoxy resin (A). Examples thereof include polyaddition-type curing agent, a catalytic curing agent, and a condensation-type curing agent.

Examples of the polyaddition-type curing agent include polyamine compounds including an aliphatic polyamine such as diethylenetriamine (DETA), triethylenetetramine (TETA), or meta-xylenediamine (MXDA), an aromatic polyamine such as diaminodiphenylmethane (DDM), m-phenylenediamine (MPDA), or diaminodiphenylsulfone (DDS), dicyandiamide (DICY), organic acid dihydrazide, and the like; acid anhydrides including an alicyclic acid anhydride such as hexahydrophthalic anhydride (HHPA) or methyltetrahydrophthalic anhydride (MTHPA) and an aromatic acid anhydride such as trimellitic anhydride (TMA), pyromellitic anhydride (PMDA), benzophenonetetracarboxylic dianhydride (BTDA); a polyphenol compound such as a novolac-type phenol resin or a phenol polymer; a polymercaptan compound such as polysulfide, thioester, or thioether; an isocyanate compound such as an isocyanate prepolymer or blocked isocyanate; organic acids such as carboxylic acid-containing polyester resin; phenolic resin-based curing agents which will be specifically described below; and the like.

Examples of the catalytic curing agent include a tertiary amine compound such as benzyldimethylamine (BDMA) or 2,4,6-tris dimethylaminomethylphenol (DMP-30); an imidazole compound such as 2-methylimidazole or 2-ethyl-4-methylimidazole (EMI 24); a Lewis acid such as a BF₃ complex; and the like.

Examples of the condensation-type curing agent include a resol-type phenolic resin; a urea resin such as a methylol group-containing urea resin; a methylol group-containing melamine resin; and the like.

Among these, as the curing agent (B), a phenolic resin-based curing agent is preferable. By the use of the phenolic resin-based curing agent, flame resistance, moisture resistance, electrical characteristics, curing properties, storage stability, and the like can be exhibited to be well-balanced. The phenolic resin-based curing agent refers to a compound (a monomer, an oligomer, and a polymer) having two or more phenolic hydroxyl groups in a molecule, and the molecular weight as well as the molecular structure thereof are not particularly limited.

Examples of the phenolic resin-based curing agent include a novolac-type resin such as a phenol novolac resin or a cresol novolac resin; a polyfunctional phenolic resin such as a triphenol methane-type phenolic resin; a modified phenolic resin such as a terpene-modified phenolic resin or a dicyclopentadiene-modified phenolic resin; an aralkyl-type resin such as a phenol aralkyl resin having a phenylene skeleton and/or a biphenylene skeleton or a naphthol aralkyl resin having a phenylene and/or biphenylene skeleton; a bisphenol compound such as bisphenol A or bisphenol F; and the like. One kind of these may be used singly, or two or more kinds thereof may be used in combination.

As the curing agent (B), an aralkyl-type resin represented by Formula (5) is preferable.

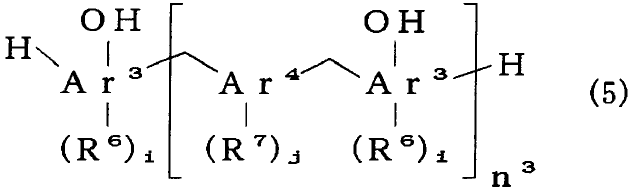

In Formula (5), Ar³ represents a phenylene group (a group including a phenol structure obtained by removing hydrogen atoms from phenol by the number of bonds) or a naphthylene group (a group including a naphthalene structure obtained by removing hydrogen atoms from naphthalene by the number of bonds). In a case where Ar³ represents a naphthylene group, a hydroxyl group may be bonded to any one of the α-position and the β-position. Ar⁴ represents any one of a phenylene group, a biphenylene group (a group including a biphenylene structure obtained by removing hydrogen atoms from biphenyl by the number of bonds), and a naphthylene group. R⁶ and R⁷ each independently represent a hydrocarbon group having 1 to 10 carbon atoms. i represents an integer of 0 to 5 (here, in a case where Ar³ represents a phenylene group, i represents an integer of 0 to 3). j represents an integer of 0 to 8 (here, in a case where Ar⁴ represents a phenylene group, j represents an integer of 0 to 4, and in a case where Ar⁴ represents a biphenylene group, j represents an integer of 0 to 6). n³ represents a degree of polymerization, and the average thereof is 1 to 3.

As Ar³, a phenylene group is preferable. As Ar⁴, a phenylene group or a biphenylene group is preferable. In a case where Ar⁴ represents a phenylene group or a biphenylene group (in a case where a phenylene skeleton or a bipenylene skeleton is introduced into the resin), flame retardancy and the like can also be improved. In a case where i and j in R⁶ and R⁷ are not zero, examples of the hydrocarbon group having 1 to 10 carbon atoms include those represented by R³ and R⁴ in Formula (3). i and j are preferably zero.

Although the content of the curing agent (B) is not particularly limited, the lower limit thereof is preferably 0. 5% by mass and more preferably 2% by mass. In a case where the content of the curing agent (B) is equal to or greater than the aforementioned lower limit, sufficient curing properties, adhesion, and the like can be exhibited. The upper limit of the content of the curing agent (B) is preferably 15% by mass, and more preferably 10% by mass. In a case where the content of the curing agent (B) is equal to or less than the aforementioned upper limit, sufficient fluidity and the like can be exhibited.

### [Inorganic filler (C)]

As the inorganic filler (C), it is possible to use inorganic fillers used in general resin compositions for sealing. Examples of the inorganic filler (C) include silica such as molten spherical silica, molten pulverized silica, or crystal silica, talc, alumina, titanium white, silicon nitride, and the like. Among these, silica is preferable, and molten spherical silica is more preferable. One kind of the inorganic filler (C) may be used singly, or two or more kinds thereof may be used in combination. The inorganic filler (C) has a spherical shape, and preferably has a wide particle size distribution. The use of such an inorganic filler makes it possible to inhibit an increase in melt viscosity of the resin composition for sealing and to increase the content of the inorganic filler (C) . As a method for adding the inorganic filler (C) having a wide particle size distribution to the resin composition for sealing, there is a method of using plural kinds of inorganic fillers having different average particle sizes by mixing them together. Furthermore, the surface of the inorganic filler (C) may be treated with a coupling agent. If necessary, the inorganic filler (C) may be used after being pre-treated with an epoxy resin or the like.

Although the average particle size of the inorganic filler (C) is not particularly limited, the lower limit thereof is preferably 0.1 µm and more preferably 0.3 µm. The upper limit thereof is preferably 40 µm, and more preferably 35 µm. The lower limit of a specific surface area of the inorganic filler (C) is preferably 1 m²/g, and more preferably 3 m²/g. The upper limit thereof is preferably 10 m²/g, and more preferably 7 m²/g. In a case where the average particle size or the specific surface area of the inorganic filler is equal to or greater than the aforementioned lower limit and equal to or less than the aforementioned upper limit, fluidity, low water absorption properties, and the like can be improved.

If necessary, it is preferable that two or more kinds of inorganic fillers within the above preferred range, for example, an inorganic filler having an average particle size of equal to or greater than 0.1 µm and equal to or less than 1 µm and an inorganic filler having an average particle size of equal to or greater than 10 µm and equal to or less than 40 µm, are used in combination.

Although the content of the inorganic filler (C) is not particularly limited, the lower limit thereof is preferably 70% by mass and more preferably 80% by mass. In a case where the content of the inorganic filler (C) is equal to or greater than the aforementioned lower limit, sufficient low water absorption properties, low thermal expansion properties, and the like can be exhibited. The upper limit of the content of the inorganic filler (C) is preferably 95% by mass, and more preferably 92% by mass. In a case where the content of the inorganic filler (C) is equal to or less than the aforementioned upper limit, sufficient fluidity and the like can be exhibited.

### [Compound (D)]

The compound (D) is a compound represented by Formula (1 as described by the formulae (1) and(2) in present claim 1. ). One kind of the compound (D) may be used singly, or two or more kinds thereof maybe used in combination. The resin composition for sealing of the present embodiment contains a specific compound (D) having a hydroxybenzoyl group. Therefore, the composition can achieve both the sufficient adhesion and the excellent high-temperature storage characteristics of the obtained electronic component device for the following reason. Although there is no certainty, for example, it is considered that because an electron-donating hydroxyl group is linked to an electron-withdrawing carbonyl group on a benzene ring, an appropriate polarization state may be expressed, and hence the affinity of the compound (D) in such a state with a metal included in an electronic component may be improved. It is considered that in a case where R¹ represents a polar group, as described in present claim 1 the affinity may be further improved. It is considered that consequently, the adhesion of the cured substance (sealing material) of the resin composition for sealing with respect to a substance to be sealed such as an electronic component may be improved, the compound (D) may capture the metal atoms diffused into the cured substance from a bonding wire or the like, and hence the deterioration of high-temperature storage characteristics may be inhibited. In order to bring about the aforementioned effect by creating a better polarization state, it is more preferable that the hydroxyl group and the carbonyl group are disposed in an ortho-position or a para-position.

As a compound, in which R¹ is represented by Formula (2), is used as the compound (D), two kinds of compounds generating such a compound through a reaction may be used by being mixed together. Examples of the two kinds of compounds include a combination of hydroxybenzoic acid and aminotriazole, and the like.

Although the content of the compound (D) is not particularly limited, the lower limit thereof is preferably 0.01% by mass, more preferably 0.02% by mass, and even more preferably 0.03% by mass. The upper limit of the content of the compound (D) is preferably 1% by mass, more preferably 0.5% by mass, and even more preferably 0.3% by mass. In a case where the content of the compound (D) is equal to or greater than the aforementioned lower limit and equal to or less than the aforementioned upper limit, sufficient adhesion and the high-temperature storage characteristics can be exhibited without greatly affecting other characteristics.

### [Coupling agent (E)]

The resin composition for sealing may further contain the coupling agent (E). The coupling agent (E) is a component that links the epoxy resin (A), which is a resin component, or the like to the inorganic filler (C). Examples of the coupling agent (E) include silane coupling agents such as epoxysilane, aminosilane, mercaptosilane (a silane coupling agent containing a mercapto group) (E1), and the like. One kind of the coupling agent (E) may be used singly, or two or more kinds thereof may be used in combination.

Examples of the epoxysilane include γ-glycidoxypropyl triethoxysilane, γ-glycidoxypropyl trimethoxysilane, β-(3,4 epoxycyclohexyl)ethyl trimethoxysilane, and the like.

Examples of the aminosilane include γ-aminopropyl triethoxysilane, γ-aminopropyl trimethoxysilane, N-phenyl-γ-aminopropyl trimethoxysilane (referred to as anilinosilane in some cases), and the like.

Examples of the mercaptosilane (E1) include γ-mercaptopropyl trimethoxysilane, 3-mercaptopropylmethyl dimethoxysilane, and the like. The mercaptosilane also includes compounds performing the same function through thermal decomposition, such as bis(3-triethoxysilylpropyl)tetrasulfide and bis(3-triethoxysilylpropyl)disulfide.

Among the coupling agents (E), it is preferable to use epoxysilane, anilinosilane, mercaptosilane (E1), or a combination of these. The anilinosilane is effective for improving fluidity, and the mercaptosilane (E1) can improve adhesion. As described above, the high-temperature storage characteristics of the compound having a mercapto group are not sufficient in some cases. However, in a case where the mercaptosilane (E1) and the compound (D) of the present invention are used in combination, excellent high-temperature storage characteristics and excellent adhesion can be simultaneously achieved.

Although the content of the coupling agent (E) is not particularly limited, the lower limit thereof is preferably 0.01% by mass and more preferably 0.05% by mass. The upper limit thereof is preferably 1% by mass, and more preferably 0.5% by mass. In a case where the content of the coupling agent (E) is equal to or greater than the aforementioned lower limit and equal to or less than the aforementioned upper limit, the function of the coupling agent (E) can be effectively exhibited.

In a case where the compound (D) and the mercaptosilane (E1) are used in combination, the lower limit of the content of the mercaptosilane is preferably 0. 01% by mass and more preferably 0. 02% by mass. In a case where the content of the mercaptosilane (E1) is equal to or greater than the aforementioned lower limit, the adhesion can be effectively improved. The upper limit of the content of the mercaptosilane (E1) is preferably 0.1% by mass, and more preferably 0.07% by mass. In a case where the content of the mercaptosilane (E1) is equal to or less than the aforementioned upper limit, the high-temperature storage characteristics can be further improved.

### [Curing accelerator (F)]

The resin composition for sealing contains the curing accelerator (F) as described in the present claims. The curing accelerator (F) is a component that functions to accelerate the reaction between the epoxy resin (A) and the curing agent (B) .

From the viewpoint of solder resistance, fluidity, the adduct of a phosphine compound and a quinone compound is used

### (Adduct of phosphine compound and quinone compound)

Examples of the adduct of a phosphine compound and a quinone compound include a compound represented by Formula (8).

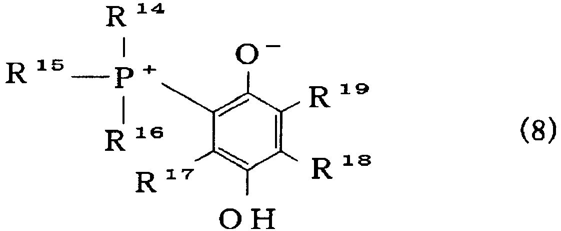

In Formula (8), P represents a phosphorus atom. R¹⁴, R¹⁵, and R¹⁶ each independently represent an alkyl group having 1 to 12 carbon atoms or an aryl group having 6 to 12 carbon atoms. R¹⁷, R¹⁸, and R¹⁹ each independently represent a hydrogen atom or a hydrocarbon group having 1 to 12 carbon atoms, and R¹⁸ and R¹⁹ may form a cyclic structure by being bonded to each other.

As the phosphine compound used in the adduct of a phosphine compound and a quinone compound, for example, triphenylphosphine, tris(alkylphenyl)phosphine, tris(alkoxyphenyl)phosphine, trinaphthylphosphine, and tris(benzyl)phosphine are preferable which have no substituent or have a substituent such as an alkyl group or an alkoxy group on an aromatic ring. Examples of the substituent such as an alkyl group or an alkoxy group include those having 1 to 6 carbon atoms. From the viewpoint of ease of availability, triphenylphosphine is preferable.

Examples of the quinone compound used in the adduct of a phosphine compound and a quinone compound include benzoquinone, anthraquinones, and the like. Among these, in view of storage stability, p-benzoquinone is preferable.

The adduct of a phosphine compound and a quinone compound can be manufactured by, for example, a method of obtaining the adduct by bringing an organic tertiary phosphine into contact with benzoquinones or by mixing the compounds together in a solvent which can dissolve both the compounds. As the solvent, ketones such as acetone or methyl ethyl ketone that hardly dissolve the adduct are preferable, but the solvent is not limited thereto.

As the compound represented by Formula (8), a compound in which R¹⁴, R¹⁵, and R¹⁶ bonded to a phosphorus atom each represent a phenyl group, and R¹⁷, R¹⁸, and R¹⁹ each represent a hydrogen atom, that is, a compound which is an adduct of 1,4-benzoquinone and triphenylphosphine is preferable, because such a compound reduces the thermal elastic modulus of the cured substance of the resin composition.

From the viewpoint of the adhesion at a high temperature and the like the adduct of a phosphine compound and a quinone compound is used.

Although the content of the curing accelerator (F) is not particularly limited, the lower limit thereof is preferably 0.1% by mass, and more preferably 0.2% by mass. In a case where the content of the curing accelerator (F) is equal to or greater than the aforementioned lower limit, sufficient curing properties and the like can be obtained. The upper limit of the content of the curing accelerator (F) is preferably 1% by mass, and more preferably 0.5% by mass. In a case where the content of the curing accelerator (F) is equal to or less than the aforementioned upper limit, sufficient fluidity and the like can be obtained.

### [Other components]

If necessary, the resin composition for sealing may contain other components. Examples of other components include a coloring agent, an ion scavenger, a release agent, a low-stress component, a flame retardant, and the like.

Examples of the coloring agent include carbon black, red oxide, and the like.

Examples of the ion scavenger include hydrotalcite and the like. The ion scavenger is used as a neutralizing agent in some cases.

Examples of the release agent include natural wax such as carnauba wax, synthetic wax, a higher fatty acid such as zinc stearate and a metal salt thereof, paraffin, and the like.

Examples of the low-stress component include silicone oil, silicone rubber, and the like.

Examples of the flame retardant include aluminum hydroxide, magnesium hydroxide, zinc borate, zinc molybdate, phosphagen, and the like.

In a case where a sulfur atom-containing compound other than mercaptosilane is used in the resin composition for sealing of the present embodiment, the upper limit of the content of the sulfur atom-containing compound other than mercaptosilane is preferably 0.3% by mass, and more preferably 0.1% by mass. In a case where the content of the sulfur atom-containing compound is equal to or less than the aforementioned upper limit, the high-temperature storage characteristics and the like can be improved. The lower limit of the content of the sulfur atom-containing compound other than mercaptosilane may be 0% by mass, and is preferably 0.01% by mass. In a case where the content of the sulfur atom-containing compound other than mercaptosilane is equal to or greater than the aforementioned lower limit, a certain extent of adhesion can be ensured.

The resin composition for sealing of the present embodiment can be prepared by the following method, for example. First, the components described above are homogeneously mixed together at room temperature by using a mixer or the like. Then, if necessary, the mixture is melted and kneaded using a kneading machine such as a heating roll, a kneader, or an extruder. Thereafter, if necessary, the obtained kneaded material is cooled and ground such that the dispersity, fluidity, or the like is adjusted as desired, and in this way, the resin composition for sealing can be obtained. The resin composition for sealing of the present embodiment can be used in the form of powder, varnish by using an organic solvent, or a liquid composition by using a liquid epoxy resin. In a case where the resin composition contains a solvent, the content of each component is expressed in terms of the solid content.

### [Electronic component device]

As shown in Fig. 1, an electronic component device 10 according to a second embodiment of the present invention has an electronic component 11 and a sealing material 12 sealing the electronic component 11. Specifically, the electronic component 11 is fixed onto a die pad 13 through a cured die-bonding material 14. The electronic component device 10 has a lead frame 16 connected thereto through a bonding wire 15 from an electrode pad (not shown in the drawing) of the electronic component 11.

The electronic component (element) 11 sealed refers to, for example, a component (element) that produces output in response to input of electric power. Specifically, examples of the electronic component 11 include an integrated circuit, a large-scale integrated circuit, a transistor, a thyristor, a diode, a solid-state imaging element, other semiconductor elements, and the like. The sealing material 12 is a cured substance of the resin composition for sealing according to the first embodiment. As the bonding wire 15, a gold wire, a copper wire, and the like can be used. As the material of the lead frame 16, copper, a copper alloy, a 42 alloy, or the like can be used.

The electronic component device 10 can be in the form of, for example, a dual in-line package (DIP), a plastic leaded chip carrier (PLCC), a quad flat package (QFP), a low-profile quad flat package (LQFP), a small outline package (SOP), a small outline J-leaded package (SOJ), a thin small outline package (TSOP), a thin quad flat package (TQFP), a tape carrier package (TCP), a ball grid array (BGA), and a chip size package (CSP), but are not limited to these.

The electronic component device 10 is manufactured by, for example, fixing the electronic component 11 onto the die pad 13 by using a die-bonding material, connecting the lead frame 16 thereto through the bonding wire 15, and then sealing the structure (material to be sealed) by using the resin composition for sealing. The sealing can be performed by, for example, installing a material to be sealed, which is formed of the electronic component 11 or the like, in a mold cavity, then molding and curing the resin composition for sealing by a molding method such as transfer molding, compression molding, or injection molding. If necessary, the electronic component device 10 in which the electronic component 11 is sealed is mounted on an electronic instrument or the like after the resin composition for sealing is cured for about 10 minutes to 10 hours at a temperature of about 80°C to 200°C.

In the electronic component device 10, the resin composition for sealing according to the first embodiment is used as the sealing material 12. Accordingly, the adhesion between the sealing material 12 and the electronic component 11, the bonding wire 15, the lead frame 16, and the like is sufficient, and the high-temperature storage characteristics thereof are excellent. Particularly, even in a case where a copper wire is used as the bonding wire 15 or the like, sufficient high-temperature storage characteristics and the like can be exhibited.

The present invention is not limited to the embodiments described above, and the constitution of the present invention can be modified within a scope that does not depart from the gist of the present invention.

### Examples

Hereinafter, the present invention will be specifically described using examples, but the present invention is not limited to the examples.

The components used in Examples 1 to 8 and Comparative Examples 1 and 2 are as below.

### Epoxy resin (A)

- Epoxy resin 1: phenolaralkyl-type epoxy resin having phenylene skeleton (trade name: NC-2000 manufactured by Nippon Kayaku Co., Ltd.)
- Epoxy resin 2: biphenyl-type epoxy resin (trade name: YX4000K manufactured by Mitsubishi Chemical Corporation)

### Curing agent (B)

- Phenolic resin-based curing agent 1: phenolaralkyl resin having biphenylene skeleton (trade name: GPH-65 manufactured by Nippon Kayaku Co., Ltd.)
- Phenolic resin-based curing agent 2: phenol novolac resin (trade name: PR-HF-3 manufactured by Sumitomo Bakelite Co., Ltd.)

### Inorganic filler (C)

- Inorganic filler 1: spherical molten silica having average particle size of 30 µm and specific surface area of 1.7 m²/g
- Inorganic filler 2: spherical molten silica having average particle size of 0.5 µm and specific surface area of 5.9 m²/g

### Compound (D)

- Compound 1: N-(2H-1,2,4-triazol-5-yl)salicylamide represented by Formula (10) (CDA-1 manufactured by ADEKA CORPORATION) 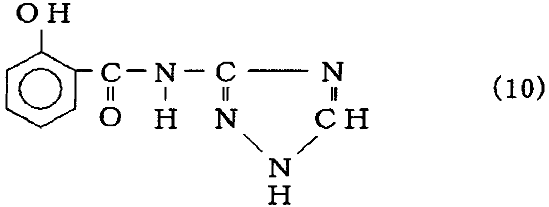
- Compound 2: 2-hydroxybenzoic acid
- Compound 3: methyl 4-hydroxybenzoate

### Compound (d)

- Compound 4: 3-amino-5-mercapto-1,2,4-triazole represented by Formula (11)

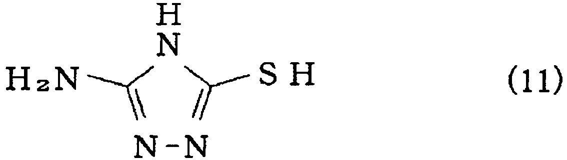

### Coupling agent (E)

- Coupling agent 1: N-phenyl-γ-aminopropyl trimethoxysilane
- Coupling agent 2: γ-mercaptopropyl trimethoxysilane

### Curing accelerator (F)

- Curing accelerator 1: triphenylphosphine-1,4-benzoquinone adduct represented by Formula (12) synthesized by the following method

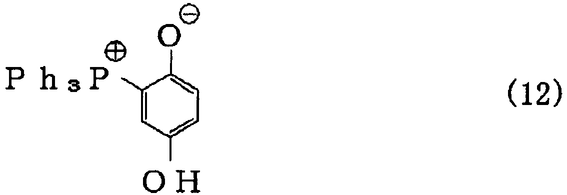

### (Synthesis of curing accelerator 1)

A separable flask equipped with a cooling tube and a stirring device was filled with 6.49 g (0.060 mol) of benzoquinone, 17.3 g (0.066 mol) of triphenylphosphine, and 40 ml of acetone, and the components were reacted by stirring at room temperature. The precipitated crystals were washed with acetone and then filtered and dried, thereby obtaining a curing accelerator 1 which were dark green crystals.
- Curing accelerator 2: tetrasubstituted phosphonium compound represented by Formula (13) synthesized by the following method

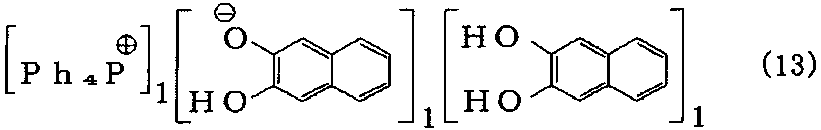

### (Synthesis of curing accelerator 2)

A separable flask equipped with a cooling tube and a stirring device was filled with 12.81 g (0.080 mol) of 2,3-dihydroxynaphthalene, 16.77 g(0.040 mol) of tetraphenylphosphonium bromide, and 100 ml of methanol, and the components were homogeneously dissolved by stirring. A sodium hydroxide solution, which was obtained by dissolving in advance 1.60 g (0.04 ml) of sodium hydroxide in 10 ml of methanol, was slowly added dropwise to the solution in the flask, and as a result, crystals were precipitated. The precipitated crystals were filtered, rinsed with water, and vacuum-dried, thereby obtaining a curing accelerator 2.

### Other components

- Coloring agent: carbon black
- Ion scavenger: hydrotalcite (DHT-4H manufactured by Kyowa Chemical Industry Co., Ltd.)
- Release agent: carnauba wax (NIKKO CARNAUBA manufactured by Nikko Fine Products Co., Ltd.)

### [Example 1]

The epoxy resin 1 (8.7 parts by mass), the phenolic resin-based curing agent 1 (6.4 parts by mass), the inorganic filler 1 (73.72 parts by mass), the inorganic filler 2 (10 parts by mass), the compound 1 (0.03 parts by mass), the coupling agent 1 (0.2 parts by mass), the curing accelerator 1 (0.25 parts by mass), the coloring agent (0.4 parts by mass), the ion scavenger (0.1 parts by mass), and the release agent (0.2 parts by mass) were mixed together at room temperature by using a mixer and then kneaded with a roll at 70°C to 100 °C. Thereafter, the kneaded material was cooled and then ground, thereby obtaining a resin composition for sealing of Example 1.

### [Examples 2 to 8 and Comparative Examples 1 and 2]

Resin compositions for sealing of Examples 2 to 8 and Comparative Examples 1 and 2 were obtained in the same manner as in Example 1, except that the amount of each component used (formulated) was changed as shown in Table 1. Note Examples 2,3 and 6 in Table 1 are not inventive.

### [Manufacturing of semiconductor device (electronic component device)]

A test element group (TEG) chip (3.5 mm x 3.5 mm) was mounted on 352-pin BGA (substrate: bismaleimide·triazine resin/glass cloth substrate having thickness of 0.56 mm, package size: 30 mm x 30 mm with thickness of 1.17 mm). Then, by using a copper wire (copper purity: 99.99% by mass, diameter: 25 µm), the resultant was wire-bonded to an electrode pad at a wire pitch of 80 µm.

The structure obtained in this way was sealed and molded using the resin composition for sealing of each of the examples and comparative examples by using a low-pressure transfer molding machine ("Y series" manufactured by TOWA Corporation), under the conditions of a mold temperature of 175°C, an injection pressure of 6.9 MPa, and a curing time of 2 minutes. In this way, a 352-pin BGA package was prepared. Then, the obtained BGA package was post-cured under the conditions of 175°C and 4 hours, thereby obtaining a semiconductor device (electronic component device).

### [Evaluation]

The obtained resin composition for sealing and semiconductor device of each of the examples and comparative examples were evaluated by the following method. The evaluation results are shown in Table 1.

### [Adhesion]

The adhesion with respect to each metal (Ag, Cu, pre-plated frame (PPF), Ni) was evaluated by the following method. On a substrate formed of each of the aforementioned metals, the obtained resin composition for sealing was integrally molded under the conditions of 175°C, 6.9 MPa, and 2 minutes and then post-cured for 4 hours at 175°C. Thereafter, the shear bond strength thereof with respect to each substrate was measured under the condition of 260°C. The numerical values shown in Table 1 are relative values based on Comparative Example 2.

### [High-temperature storage characteristics]

The obtained semiconductor devices were subjected to a high-temperature storage test (HTSL) by the following method. Each of the semiconductor devices was stored under the condition of a temperature of 200°C for 1,000 hours. For the semiconductor device having undergone storage, an electrical resistivity between the wire and the electrode pad was measured. A semiconductor device showing an average electrical resistivity that was less than 110% of an average initial resistivity thereof was denoted by A; a semiconductor device showing an electrical resistivity that was equal to or higher than 110% and equal to or lower than 120% of an average initial resistivity thereof was denoted by B; and a semiconductor device showing an electrical resistivity that was higher than 120% of an average initial resistivity thereof was denoted by X.

**[Table 1]**

| | | Example 1 | Example 2 | Example 3 | Example 4 | Example 5 | Example 6 | Example 7 | Example 8 | Comparative Example 1 | Comparative Example 2 |
|---|---|---|---|---|---|---|---|---|---|---|---|
| [A] | Epoxy resin 1 | 8.7 | 8.7 | 8.7 | | 8.7 | 8.7 | | 8.7 | 8.7 | 8.7 |
| | Epoxy resin 2 | | | | 4.4 | | | 4.4 | | | |
| [B] | Phenolic resin-based curing agent 1 | 6.4 | 6.4 | 6.4 | | 6.4 | 6.4 | | 6.4 I | 6.4 | 6.4 |
| | Phenolic resin-based curing agent 2 | | | | 3.5 | | | 3.5 | | | |
| [C] | Inorganic filler 1 | 73.72 | 73.72 | 73.7 | 75.92 | 73.72 | 73.72 | 75.92 | 73.6 | 73.75 | 73.72 |
| | Inorganic filler 2 | 10 | 10 | 10 | 15 | 10 | 10 | 15 | 10 | 10 | 10 |
| [D] | Compound 1 | 0.03 | | | 0.03 | 0.03 | | 0.03 | 0.15 | | |
| | Compound 2 | | 0.03 | | | | 0.03 | | | | |
| | Compound 3 | | | 0.05 | | | | | | | |
| [d] | Compound 4 | | | | | | | | | | 0.03 |
| [E] | Coupling agent 1 | 0.2 | 0.2 | 0.2 | 0.2 | 0.15 | 0.15 | 0.15 | 0.2 | | 0.15 |
| | Coupling agent 2 | | | | | 0.05 | 0.05 | 0.05 | | 0.2 | 0.05 |
| [F] | Curing accelerator 1 | 0.25 | 0.25 | 0.25 | | 0.25 | 0.25 | | 0.25 | 0.25 | 0.25 |
| | Curing accelerator 2 | | | | 0.25 | | | 0.25 | | | |
| Other compon ents | Coloring agent | 0.4 | 0.4 | 0.4 | 0.4 | 0.4 | 0.4 | 0.4 | 0.4 | 0.4 | 0.4 |
| | Ion scavenger | 0.1 | 0.1 | 0.1 | 0.1 | 0.1 | 0.1 | 0.1 | 0.1 | 0.1 | 0.1 |
| | Release agent | 0.2 | 0.2 | 0.2 | 0.2 | 0.2 | 0.2 | 0.2 | 0.2 | 0.2 | 0.2 |
| Total | | 100 | 100 | 100 | 100 | 100 | 100 | 100 | 100 | 100 | 100 |
| Evalua tion | Adhesion ¹⁾ Ag (260°C) | 1.1 | 1 | 1 | 1.1 | 1.5 | 1.3 | 1.5 | 1.2 | 0.7 | 1 |
| | Adhesion ¹⁾ Cu (260°C) | 1.2 | 1 | 1 | 1.2 | 1.8 | 1.5 | 1.7 | 1.3 | 0.7 | 1 |
| | Adhesion ¹⁾ PPF (260°C) | 1.1 | 1 | 1 | 1.2 | 1.4 | 1.3 | 1.3 | 1.1 | 0.6 | 1 |
| | Adhesion ¹⁾ Ni (260°C) | 1.3 | 1.1 | 1 | 1.2 | 1.9 | 1.6 | 1.7 | 1.4 | 0.7 | 1 |
| | High-temperature storage characteristics | A | A | B | A | A | A | | A | X | X |

| | | | | | | | | | | | |
|---|---|---|---|---|---|---|---|---|---|---|---|
| 1) Relative value based on Comparative Example 2 | | | | | | | | | | | |

As is evident from Table 1, the resin compositions for sealing of examples have sufficient adhesion, and the high-temperature storage characteristics of the obtained electronic component devices (semiconductor devices) are also excellent. Specifically, in Comparative Example 1 that does not contain the compound (D), the adhesion and the high-temperature storage characteristics are relatively poor, the structure represented by Formula (1) does not exist. In Comparative Example 2 that contains the compound 4 (3-amino-5-mercapto-1,2,4-triazole) having a mercapto group, the adhesion is higher than that in Comparative Example 1, but the high-temperature storage characteristics are not improved. In contrast, in Examples 1 to 8 that contain the compound (D), the adhesion is equivalent to or better than the adhesion of Comparative Example 2, and the high-temperature storage characteristics are improved. Particularly, it is understood that in a case where the compound 1 having an amino group or the compound 2 having a hydroxyl group is used as the compound (D), the adhesion and the high-temperature storage characteristics are further improved (Examples 1, 2, and 4 to 8). Furthermore, it is understood that in a case where the compound 1 having an amino group is used, the adhesion and the high-temperature storage characteristics are further improved (Examples 1, 4, 5, 7, and 8). It is also understood that in a case where the compound (D) and mercaptosilane (coupling agent 2) as the coupling agent (E) are used in combination, excellent high-temperature storage characteristics can be maintained even though the resin composition does not contain the compound (coupling agent 2) having a mercapto group, and the adhesion is further improved (Examples 5 to 7).

## Claims

1. A resin composition for sealing comprising:
an epoxy resin (A);
a curing agent (B);
an inorganic filler (C);
a compound (D) represented by Formula (1); and
a curing accelerator (F) 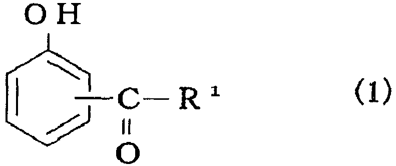 wherein R¹ is represented by Formula (2); and 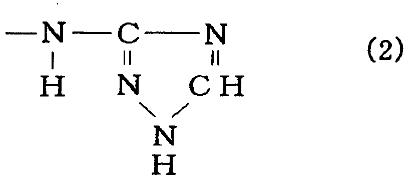 wherein the curing accelerator (F) is an adduct of a phosphine compound and a quinone compound.

2. The resin composition for sealing according to claim 1,
wherein a content of the compound (D) is equal to or greater than 0.01% by mass and equal to or less than 1% by mass with respect to a total amount of the resin composition for sealing.

3. The resin composition for sealing according to claim 1 or 2, further comprising:
a coupling agent (E),
wherein the coupling agent (E) includes a silane coupling agent (E1) having a mercapto group.

4. The resin composition for sealing according to claim 3,
wherein a content of the silane coupling agent (E1) having a mercapto group is equal to or greater than 0.01% by mass and equal to or less than 0.1% by mass with respect to the total amount of the resin composition for sealing.

5. The resin composition for sealing according to any one of claims 1 to 4 that is used for sealing an electronic component to which a copper wire is connected.

6. An electronic component device comprising:
an electronic component; and
a sealing material sealing the electronic component,
wherein the sealing material is a cured substance of the resin composition for sealing according to any one of claims 1 to 4.

7. The electronic component device according to claim 6, further comprising:
a copper wire connected to the electronic component.

## Patentansprüche

1. Harzzusammensetzung zum Versiegeln, umfassend:
ein Epoxidharz (A);
ein Härtungsmittel (B);
einen anorganischen Füllstoff (C);
eine Verbindung (D), dargestellt durch die Formel (1); und
einen Härtungsbeschleuniger (F) 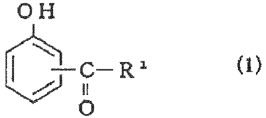 wobei R¹ durch die Formel (2) dargestellt wird; und 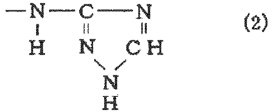 wobei der Härtungsbeschleuniger (F) ein Addukt aus einer Phosphinverbindung und einer Chinonverbindung ist.

2. Harzzusammensetzung zum Versiegeln nach Anspruch 1,
wobei ein Gehalt der Verbindung (D) gleich oder größer als 0,01 Massen-% und gleich oder kleiner als 1 Massen-%, bezogen auf eine Gesamtmenge der Harzzusammensetzung zum Versiegeln, ist.

3. Harzzusammensetzung zum Versiegeln nach Anspruch 1 oder 2, weiter umfassend:
einen Haftvermittler (E),
wobei der Haftvermittler (E) einen Silan-Haftvermittler (E1) mit einer Mercaptogruppe enthält.

4. Harzzusammensetzung zum Versiegeln nach Anspruch 3,
wobei ein Gehalt des Silan-Haftvermittlers (E1) mit einer Mercaptogruppe gleich oder größer als 0,01 Massen-% und gleich oder kleiner als 0,1 Massen-%, bezogen auf die Gesamtmenge der Harzzusammensetzung zum Versiegeln, ist.

5. Harzzusammensetzung zum Versiegeln nach einem der Ansprüche 1 bis 4, die zum Versiegeln eines elektronischen Bauteils, an das ein Kupferdraht angeschlossen ist, verwendet wird.

6. Elektronisches Bauelement, umfassend:
ein elektronisches Bauteil; und
ein Versiegelungsmaterial, das das elektronische Bauteil versiegelt,
wobei das Versiegelungsmaterial eine gehärtete Substanz der Harzzusammensetzung zum Versiegeln nach einem der Ansprüche 1 bis 4 ist.

7. Elektronisches Bauelement nach Anspruch 6, weiter umfassend:
einen Kupferdraht, der mit dem elektronischen Bauteil verbunden ist.

## Revendications

1. Composition de résine de scellement, comprenant :
une résine époxy (A) ;
un agent de durcissement (B) ;
une charge inorganique (C) ;
un composé (D) représenté par la formule (1), et
un accélérateur de durcissement (F) 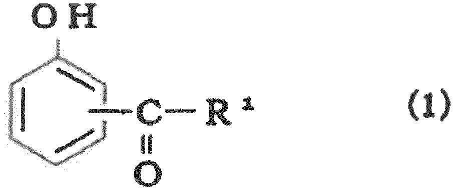 dans laquelle R¹ est représenté par la formule (2), et, 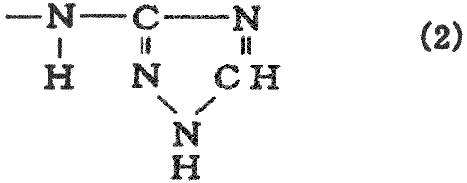 dans laquelle l'accélérateur de durcissement (F) est un adduit d'un composé phosphine et d'un composé quinone.

2. Composition de résine de scellement selon la revendication 1, dans laquelle la teneur en composé (D) est égale ou supérieure à 0,01% en masse et égale ou inférieure à 1% en masse par rapport à la quantité totale de la composition de résine de scellement.

3. Composition de résine de scellement selon la revendication 1 ou 2, comprenant en outre :
un agent de couplage (E),
dans laquelle l'agent de couplage (E) comprend un agent de couplage silane (E1) ayant un groupe mercapto.

4. Composition de résine de scellement selon la revendication 3,
dans laquelle la teneur en agent de couplage silane (E1) ayant un groupe mercapto est égale ou supérieure à 0,01% en masse et égale ou inférieure à 0,1% en masse par rapport à la quantité totale de la composition de résine de scellement.

5. Composition de résine de scellement selon l'une quelconque des revendications 1 à 4, qui est utilisée pour le scellement d'un composant électronique auquel un fil de cuivre est connecté.

6. Dispositif de composant électronique comprenant :
un composant électronique, et
un matériau de scellement scellant le composant électronique,
dans laquelle le matériau de scellement est une substance durcie de la composition de résine de scellement selon l'une quelconque des revendications 1 à 4.

7. Dispositif de composant électronique selon la revendication 6, comprenant en outre :
un fil de cuivre connecté au composant électronique.
